# EUROPEAN PATENT APPLICATION

(11) **EP 1 750 176 A2**
(43) Date of publication of application: **07.02.2007**
(21) Application number: 06118340.6
(22) Date of filing: 02.08.2006
(51) Int. Cl.: G03F 7/039

(54) **Positive-type radiation-sensitive resin composition for producing a metal-plating formed material, transcription film and production method of a metal-plating formed material**

(30) Priority: 03.08.2005 JP 2005225969
(71) Applicant: JSR Corporation, Tokyo 104-8410 (JP)
(72) Inventor: Nishikawa, Kouji, Tokyo 104-8410 (JP); Mori, Kousuke, Tokyo 104-8410 (JP); Ohta, Masaru, Tokyo 104-8410 (JP); Iwanaga, Shin-ichiro, Tokyo 104-8410 (JP)
(74) Representative: TBK-Patent

(57) **Abstract**

The positive-type radiation-sensitive resin composition for producing a metal-plating formed material relating to the present invention comprises (A) a polymer containing a structural unit having an acid-dissociative functional group, which is dissociated in the presence of an acid to generate an acidic functional group, and a crosslinking structure; (B) a radiation-sensitive acid generator; and (C) an organic solvent. The positive-type radiation-sensitive resin composition is excellent in sensitivity and resolution, exhibits excellent adhesion to a substrate, leaves no residue at an opening after development, and is capable of preventing occurrence of crack in the resin film after metal plating and push-in of plated metal into the resin film.

## Description

### TECHNICAL FIELD

The present invention relates to a positive-type radiation-sensitive resin composition suitable for producing a metal-plating formed material, a transcription film using said composition and a production method of a metal-plating formed material.

### BACKGROUND ART

In recent years, along with microminiaturization of integrated circuit devices, enhanced integration of a large scale integrated circuit (LSI) and shift to an integrated circuit adapted to specific application (Application Specific Integrated Circuit:ASIC) have been rapidly proceeding. Accordingly, a multipin thin-film packaging is needed for mounting an LSI to an electronic equipment, and there has been adopted bear-chip mounting by the tape automated bonding (TAB) method or the flip-chip method or other packaging techniques. In such a packaging method of a multi-pin thin film, it is necessary to arrange protruding electrodes with a height of 10 µm or more, called bumps, as connecting terminals with high accuracy on a substrate.

Such bumps are usually formed by the following procedures. At first, a layer of barrier metal, which serves as a conducting layer, is stacked on a wafer equipped with an LSI device, and then the wafer is coated with a radiation-sensitive resin composition (so-called resist) and dried. Next, the wafer is irradiated with radiation ray (hereafter referred to also as "exposed") through a mask to make openings in positions wherein bumps are to be formed and then developed to form a pattern. Using this pattern as a template, electrode material such as gold and copper is deposited by electroplating. Subsequently, after the resin part is peeled off, the barrier metal is removed by etching to form bumps. After that, a chip is squarely cut out from the wafer and this chip is subjected to a packaging process such as TAB or a mounting process such as flip-chip.

In the above-mentioned series of bump-forming steps, the resist requires to have the following characteristics:
(1) A coating film with a uniform thickness of 20 µm or more can be formed.
(2) The resolution is high enough to be capable of forming bumps with narrower pitch.
(3) Sidewalls of the pattern serving as a template are nearly vertical and the pattern reproduces the dimensions of mask with fidelity.
(4) The sensitivity is high and the developing characteristics are excellent in order to increase production efficiency of the step.
(5) The wettability is good for the metal plating solution.
(6) The resist does not deteriorate the metal-plating solution through dissolution to the metal-plating solution during metal plating.
(7) The adhesion to the substrate is good so that the metal-plating solution does not percolate into the interface between the substrate and the resist during metal plating.
(8) The resist can be readily peeled off with a peeling liquid after metal plating.
   Furthermore, the following characteristic is required for the deposited material obtained by metal plating.
(9) The shape of pattern used as a template is accurately transcribed and the dimensions of mask are reproduced with fidelity.

Conventionally, as resist for bump formation, there have been used a positive-type radiation-sensitive resin composition comprising Novolac resin and a compound containing a naphthoquinonediazide group as major ingredients (for example, see Japanese Patent Application Laid-Open (JP-A) No. 2000-250210). However, there was a problem that developing the resist composed of the above-mentioned composition provided not a pattern having vertical sidewalls but a pattern with an inclined shape diminishing from the substrate surface to the surface of the resist (normal tapered shape). There was another problem that the resist composed of the above-mentioned composition required a long exposure time because of its low sensitivity, lowering the production efficiency. Furthermore, insufficiency was also encountered in the resolution or the fidelity with which the thick-film material deposited by metal plating reproduced the dimensions of mask.

As resist for bump formation there has been also used a positive-type radiation-sensitive resin composition comprising a polymer containing an acid-dissociative functional group, which is dissociated in the presence of an acid to generate an acidic functional group, a component that generates an acid on irradiation with radiation ray and other additives (for example, see Japanese Patent Application Laid-Open (JP-A) No. 2001-281862). The resists composed of these compositions were excellent in sensitivity and resolution. Furthermore, by adding an alkali-soluble resin having a specific structure, adhesion during gold-plating was improved and percolation of plating solution into interface between a substrate and the resist was prevented (see Japanese Patent Application Laid-Open (JP-A) No. 2001-281863). Further, this alkali-soluble resin was excellent in preventing occurrence of breakage (crack) caused by swelling and shrinkage of the resist film ascribing metal plating. The above-mentioned resin composition comprising the above-mentioned alkali-soluble resin, however, had problems, (1) the pattern was often deformed during gold-plating at high temperatures after the pattern had been formed and (2) the size of material deposited by gold-plating was sometimes larger than the pattern size (push-in).

### OBJECT OF THE INVENTION

An object of the present invention is to provide a positive-type radiation-sensitive resin composition that is excellent in sensitivity and resolution, exhibits excellent adhesion to a substrate, leaves no residue at an opening after development, and is capable of preventing occurrence of crack in the resin film after metal plating and push-in of plated metal into the resin film; a transcription film using this composition; and a production method capable of forming a thick-film metal-plating formed material such as a bump and a wiring accurately.

### SUMMARY OF THE INVENTION

The present inventors pursued zealous study concerning the above subject. As a result they solved the above problems by forming a crosslinking structure using a compound having two or more ethylenic unsaturated double bonds on preparing a polymer containing an acid-dissociative functional group, which is dissociated in the presence of an acid to generate an acidic functional group, and preferably by increasing the average molecular weight of the polymer.

Namely, the positive-type radiation-sensitive resin composition for producing a metal-plating formed material relating to the present invention comprises (A) a polymer containing a structural unit having an acid-dissociative functional group, which is dissociated in the presence of an acid to generate an acidic functional group, and a crosslinking structure; (B) a radiation-sensitive acid generator; and (C) an organic solvent.

The polystyrene-equivalent weight average molecular weight of the above-mentioned polymer (A) determined with gel permeation chromatography is preferably in a range of 30,000 to 150,000. Preferably, the above-mentioned polymer (A) further contains at least one structural unit selected from structural units represented by the following formulae (1), (2) and (6): 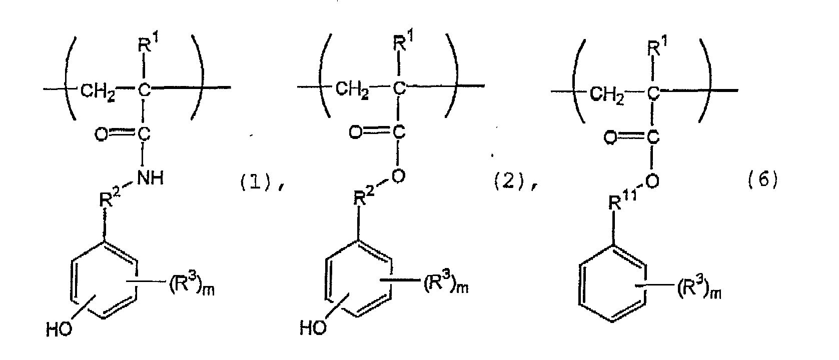 in formulae (1), (2) and (6), R¹ is a hydrogen atom or a methyl group; R² is -(CH₂)ⱼ- (j is an integer of 0 to 3) ; R³ is a hydrogen atom or an alkyl group having 1 to 4 carbon atoms; R¹¹ is -(CH₂CH₂O)ₖ- or -(CH₂CH₂CH₂O)ₖ- (k is an integer of 1 to 4); and m is an integer of 1 to 4.

The structural unit having an acid-dissociative functional group in the above-mentioned polymer (A) is preferably represented by the following formula (3): 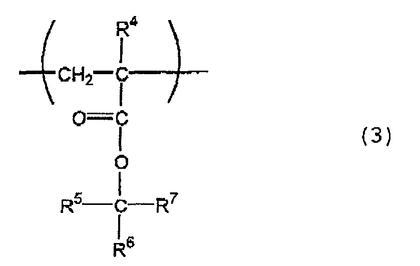 in formula (3), R⁴ is a hydrogen atom or a methyl group; each of R⁵-R⁷ is independently an alkyl group having 1 to 4 carbon atoms, an alicyclic hydrocarbon group having 4 to 20 carbon atoms, a group containing an aromatic ring or a substituted hydrocarbon group wherein at least one hydrogen atom in these groups are substituted with a polar group other than hydrocarbon groups; and when two of R⁵ -R⁷ are alkyl groups or substituted alkyl groups, their alkyl chains may bond to each other to form an alicyclic hydrocarbon group having 4 to 20 carbon atoms or a substituted alicyclic hydrocarbon group.

Furthermore, the above-mentioned polymer (A) is preferably a copolymer obtained by reacting at least a monomer that derives a structural unit having an acid-dissociative functional group and a monomer having two or more ethylenic unsaturated double bonds.

The positive-type radiation-sensitive resin composition for producing a metal-plating formed material of the present invention preferably contains the component (B) at a range of 0.1 part by weight to 20 parts by weight for 100 parts by weight of the above-mentioned component (A). Preferably the resin composition further comprises an alkali-soluble resin (D) other than the above-mentioned polymer (A). It is also preferred that the resin composition further comprises an agent for controlling diffusion of an acid.

The above-mentioned component (B) is preferably at least one kind of compound selected from the group consisting of 4-t-butylphenyldiphenylsulfonium trifluoromethanesulfonate, 4-t-butylphenyldiphenylsulfonium perfluoro-n-octanesulfonate, 4-t-butylphenyldiphenylsulfonium pyrenesulfonate and (4,7-di-n-butoxynaphthyl)tetrahydrothiophenium trifluoromethanesulfonate.

Such a positive-type radiation-sensitive resin composition is suitably used for producing a bump.

The transcription film of the present invention comprises a supporting film and a resin film formed using the above-mentioned positive-type radiation-sensitive resin composition for producing a metal-plating formed material on said supporting film. The film thickness of the above-mentioned resin film is preferably in a range between 20 µm and 200 µm.

The production method of a metal-plating formed material of the present invention comprises (1) a step of forming a resin film using the above-mentioned positive-type radiation-sensitive resin composition for producing a metal-plating formed material on a wafer provided with a barrier metal layer; (2) a step of forming a pattern by exposing the above-mentioned resin film followed by developing; (3) a step of depositing an electrode material by electroplating with the above-mentioned pattern as a template; and (4) a step of removing the barrier metal layer by etching after peeling the remaining resin film off. The resin film in the above-mentioned step (1) is preferably formed by transcribing the resin film in the above-mentioned transcription film on the wafer.

### PREFERRED EMBODIMENTS OF THE INVENTION

The following is detailed explanation of the positive-type radiation-sensitive resin composition for producing a metal-plating formed material of the present invention, the transcription film containing a resin film made of the composition and the production method for metal-plating formed materials using these.

### [Positive-type radiation-sensitive resin composition for producing a metal-plating formed material]

The positive-type radiation-sensitive resin composition for producing a metal-plating formed material of the present invention comprises (A) a polymer containing a structural unit having an acid-dissociative functional group, which is dissociated in the presence of an acid to generate an acidic functional group, and a crosslinking structure; (B) a radiation-sensitive acid generator; (C) an organic solvent; and other components if necessary.

### <Component (A)>

Component (A) composing the positive-type radiation-sensitive resin composition for producing a metal-plating formed material of the present invention is a polymer containing a structural unit having an acid-dissociative functional group, which is dissociated in the presence of an acid to generate an acidic functional group, and a crosslinking structure.

The composition of the present invention comprises component (B) (hereafter referred to also as "acid generator") that generates an acid on exposure. The acid generated on exposure reacts with the acid-dissociative functional group in component (A) to form an acidic functional group and an acid-dissociated substance. Such a decomposition reaction of an acid-dissociative functional group is accelerated by heating after exposure (Post Exposure Bake: hereafter referred to also as "PEB"), and as a result the solubility of exposed part to an aqueous alkaline solution increases and thus a desired pattern can be formed with high sensitivity (namely, with low exposure dose) and high resolution.

The above-mentioned acid-dissociative functional group is not particularly limited as long as it is dissociated in the presence of an acid to generate an acidic functional group. For example, there may be mentioned a functional group that is dissociated in the presence of an acid to generate a carboxyl group or a phenolic hydroxyl group. As preferred structural unit having an acid-dissociative functional group, there may be mentioned the unit represented by the following formula (3) :

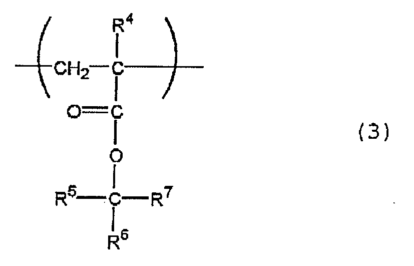

In formula (3), R⁴ is a hydrogen atom or a methyl group; each of R³ to R⁷, which may be identical or different, is independently an alkyl group having 1 to 4 carbon atoms, an alicyclic hydrocarbon group having 4 to 20 carbon atoms, a group containing an aromatic ring or a substituted hydrocarbon group wherein at least one hydrogen atom in these groups are substituted with a polar group other than hydrocarbon groups. When two of R⁵ to R⁷ are alkyl groups or substituted alkyl groups, their alkyl chains may bond to each other to form an alicyclic hydrocarbon group having 4 to 20 carbon atoms or a substituted alicyclic hydrocarbon group.

The structural unit represented by the above formula (3) is derived from the monomer represented by the following formula (3a) :

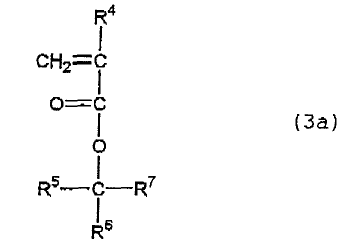

In formula (3a), R⁴ to R⁷ are as defined for R⁴ to R⁷ in formula (3).

The above-mentioned alkyl group having 1 to 4 carbon atoms may be ether linear or branched and there may be mentioned, for example, a methyl group, an ethyl group, an n-propyl group, an i-propyl group, an n-butyl group, a 2-methylpropyl group, a 1-methylpropyl group and a t-butyl group.

As the above-mentioned monovalent alicyclic hydrocarbon group having 4 to 20 carbon atoms or the above-mentioned divalent alicyclic hydrocarbon group having 4 to 20 carbon atoms formed by bonding of two alkyl chains of R⁵ to R⁷ to each other, there may be mentioned, for example, a group derived from a cycloalkane such as cyclobutane, cyclopentane, cyclohexane, cycloheptane and cyclooctane; a group derived from a bridged hydrocarbon such as adamantane, bicyclo[2.2.1]heptane, tetracyclo[6.2.1.1^{3,6}.0^{2,7}]dodecane and tricyclo[5.2.1.0^{2,6}]decane; and a group derived by substituting a hydrogen atom in such a group derived from the cycloalkane or the bridged hydrocarbon with a linear, branched or cyclic alkyl group having 1 to 4 carbon atoms such as a methyl group, an ethyl group, an n-propyl group, an i-propyl group, an n-butyl group, a 2-methylpropyl group, a 1-methylpropyl group and a t-butyl group.

As the above-mentioned group containing an aromatic ring, there may be mentioned, for example, a phenyl group, an o-tolyl group, a m-tolyl group, a p-tolyl group, a 4-chlorophenyl group, a 4-t-butylphenyl group, a 1-naphthyl group and a benzyl group.

In the above-mentioned substituted hydrocarbon group, as polar functional group other than hydrocarbon groups that can substitute a hydrogen atom, there may be mentioned, for example, a hydroxyl group; a carboxyl group; an oxo (=O) group; hydroxyalkyl groups such as a hydroxymethyl group, a 1-hydroxyethyl group, a 2-hydroxyethyl group, a 1-hydroxypropyl group, a 2-hydroxypropyl group, a 3-hydroxypropyl group, a 2-hydroxybutyl group, a 3-hydroxybutyl group and a 4-hydroxybutyl group; alkoxy groups such as a methoxy group, an ethoxy group, a propoxy group, an i-propoxy group, an n-butoxy group, a 2-methylpropoxy group, a 1-methylpropoxy group and a t-butoxy group; a cyano group; and cyanoalkyl groups such as a cyanomethyl group, a 2-cyanoethyl group, a 3-cyanopropyl group and a 4-cyanobutyl group.

As monomer (hereafter referred to as "monomer (3')) that derives the structural unit represented by the above formula (3), there may be mentioned, for example, t-butyl (meth)acrylate, 1,1-dimethylpropyl (meth)acrylate, 1,1-dimethylbutyl (meth)acrylate, 2-cyclohexylpropyl (meth)acrylate, 1,1-dimethylbenzyl (meth)acrylate, tetrahydropyranyl (meth)acrylate, 2-benzyloxycarbonylethyl (meth)acrylate, 2-methyl-2-adamantyl (meth)acrylate, 1,1-dimethyl-3-oxobutyl (meth)acrylate and 2-benzylpropyl (meth)acrylate. Of these, preferred are t-butyl (meth)acrylate and 1,1-dimethylpropyl (meth)acrylate.

Further, besides the above monomer (3'), a monomer that is dissociated in the presence of an acid to generate a phenolic hydroxyl group, can also be used as a monomer that derives the structural unit having an acid-dissociative functional group. Specifically, there may be mentioned hydroxystyrenes protected by forming an acetal group such as p-(1-methoxyethoxy)styrene and p-(1-ethoxyethoxy)styrene, t-butoxystyrene and t-butoxycarbonyloxystyrene.

These monomers may be used singly, or two or more kind of them may be used in combination.

The above-mentioned polymer (A) can be obtained by copolymerizing the above-mentioned monomer deriving a structural unit having an acid-dissociative functional group (including monomer (3')) and a monomer containing two or more ethylenic unsaturated double bonds (hereafter referred to as "monomer (I)"). Crosslinking structure is formed in polymer (A) via involvement of these two or more ethylenic unsaturated double bonds in copolymerization.

On forming a metal-plating formed material, a metal column is formed in a groove that was formed by patterning of a resin film. Force to grow in lateral direction acts on this metal column in a precipitation/deposition step. If the strength of resin film is low, sidewalls of the groove are pushed by the metal and deformed, and thus the metal column finally obtained becomes a barrel shape. However, when the positive-type radiation-sensitive resin composition of the present invention is used, because crosslinking structure is formed in the resin film, a stiff resin film can be formed and thus a metal column with vertical sidewalls can be formed.

As the above-mentioned monomer (I), there may be mentioned, for example, poly(meth)acrylates such as trimethylolpropane tri(meth)acrylate, ethylene glycol di(meth)acrylate, tetraethylene glycol di(meth)acrylate, polyethylene glycol di(meth)acrylate, 1,4-butanediol di (meth) acrylate, butylene glycol di (meth) acrylate, propylene glycol di (meth) acrylate, trimethylolpropane di (meth) acrylate, 1, 6-hexanediol di (meth) acrylate, 2,5-dimethyl-2,5-hexanediol diacrylate, neopentylglycol di(meth)acrylate, tris(2-hydroxyethyl)isocyanurate tri(meth)acrylate, tris(2-hydroxyethyl)isocyanurate di(meth)acrylate, tricyclodecanedimethanol di(meth)acrylate, epoxy(meth)acrylate given by add (meth)acrylic acid to diglycidyl ether of bisphenol A, bisphenol A di(meth)acryloyloxyethyl ether, bisphenol A di(meth)acryloyloxyethyloxyethyl ether, bisphenol A di(meth)acryloyloxymethylethyl ether, tetramethylolpropane tetra(meth)acrylate, pentaerythritol tri(meth)acrylate, pentaerythritol tetra(meth)acrylate, dipentaerythritol penta (meth) acrylate and dipentaerythritol hexa (meth) acrylate

As the above-mentioned monomer (I), commercially available compounds may be also used as received. As specific examples of such commercially available compound, there may be mentioned Aronix^{™} series (Toa Gosei Co., Ltd.) Nos. M-210, M-309, M-310, M-400, M-7100, M-8030, M-8060, M-8100, M-9050, M-240, M-245, M-6100, M-6200, M-6250, M-6300, M-6400 and M-6500; Kayarad^{™} series (Nippon Kayaku Co., Ltd.) Nos. R-551, R-712, TMPTA, HDDA, TPGDA, PEG400DA, MANDA, HX-220, HX-620, R-604, DPCA-20, DPCA-30, DPCA-60 and DPCA-120; Viscoat series (Osaka Organic Chemical Industry Ltd.) Nos. 295, 300, 260, 312, 335HP, 360, GPT, 3PA and 400; and the like.

The above-mentioned monomers (I) may be used singly, or two or more kinds of them may be used in combination. Among the above-mentioned monomers (I), trimethylolpropane tri(meth)acrylate, ethylene glycol di(meth)acrylate, 1,4-butanediol di(meth)acrylate and 1,6-hexanediol di(meth)acrylate are preferred.

Preferably the above-mentioned polymer (A) further contains at least one structural unit selected from a structural unit represented by the following formula (1) (hereafter, also referred to as "structural unit (1)"), a structural unit represented by the following formula (2) (hereafter, also referred to as "structural unit (2)") and a structural unit represented by the following formula (6) (hereafter, also referred to as "structural unit (6)").

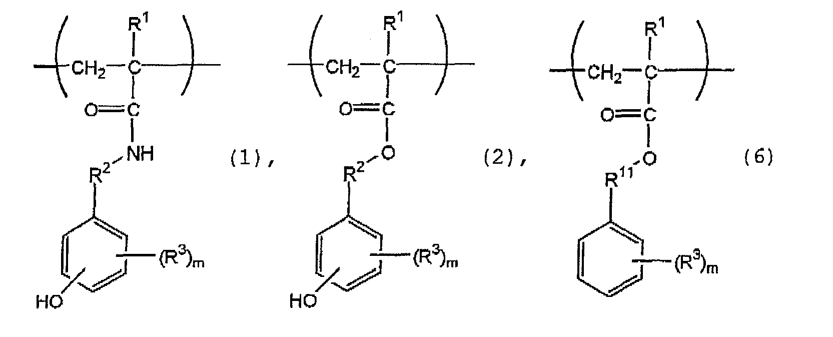

In formulae (1), (2) and (6), R¹ is a hydrogen atom or a methyl group; R² is -(CH₂)ⱼ- (j is an integer of 0 to 3); R³ is a hydrogen atom or an alkyl group having 1 to 4 carbon atoms; R¹¹ is -(CH₂CH₂O)ₖ- or -(CH₂CH₂CH₂O)ₖ- (k is an integer of 1 to 4); and m is an integer of 1 to 4.

By containing at least one structural unit selected from the above-mentioned structural units (1), (2) and (6) in polymer (A), adhesion of the resist to a substrate is improved and percolation of plating solution in the interface between the substrate and the resist during metal plating can be prevented. Further the amide moiety in the above-mentioned structural unit (1) serves as a weak base in a coating film, preventing deactivation of an acid by amines present in the environment. Moreover, by adjusting the kind and the number of substituents contained in the above structural units (1) and (2), the acidity of the phenolic hydroxyl group can be varied, and the solubility of the resist to an alkaline developer can be thus regulated.

The above-mentioned structural units (1), (2) and (6) can be derived from the monomer represented by the following formula (1a) (hereafter referred to as "monomer (1')"), the monomer represented by the following formula (2a) (hereafter referred to as "monomer (2')"), and the monomer represented by the following formula (6a) (hereafter referred to as "monomer (6')"), respectively.

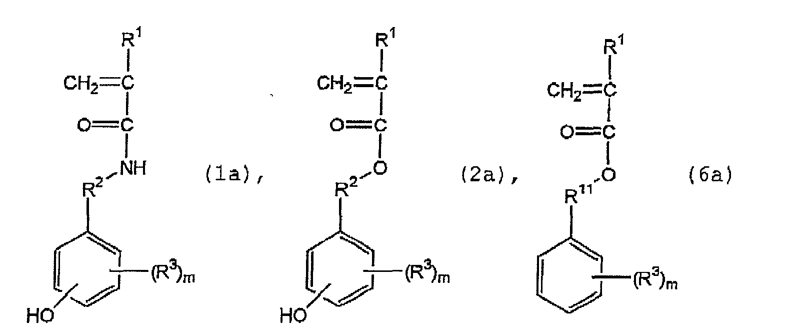

In formulae (1a), (2a) and (6a), R¹ to R³ and R¹¹ are as defined for R¹ to R³ and R¹¹ in formulae (1), (2) and (6).

As monomer (1'), there may be mentioned, for example, vinyl compounds containing an amide group such as
N-(p-hydroxyphenyl)acrylamide,
N-(p-hydroxyphenyl)methacrylamide,
N-(o-hydroxyphenyl)acrylamide,
N-(o-hydroxyphenyl)methacrylamide,
N-(m-hydroxyphenyl)acrylamide,
N-(m-hydroxyphenyl)methacrylamide,
N-(p-hydroxybenzyl)acxylamide,
N-(p-hydroxybenzyl)methacrylamide,
N-(3,5-dimethyl-4-hydroxybenzyl)acrylamide,
N-(3,5-dimethyl-4-hydroxybenzyl)methacrylamide,
N-(3,5-di-t-butyl-4-hydroxybenzyl)acrylamide,
N-(3,5-di-t-butyl-4-hyclroxybenzyl)methacrylamide,
N-(o-hydroxybenzyl)acrylamide and
N-(o-hydroxybenzyl)methacrylamide.

As monomer (2'), there may be mentioned, for example, (meth)acrylic acid esters such as p-hydroxyphenyl (meth)acrylate, o-hydroxyphenyl (meth)acrylate, m-hydroxyphenyl (meth)acrylate, p-hydroxybenzyl (meth)acrylate, 3,5-dimethyl-4-hydroxybenzyl (meth)acrylate, 3,5-di-t-butyl-4-hydroxybenzyl (meth)acrylate and o-hydroxybenzyl (meth)acrylate.

As monamex (6'), there may be mentioned, for example, phenoxyalkyl (meth)acrylates such as phenoxyethyl (meth)acrylate and phenoxypropyl (meth)acrylate; phenoxypolyalkylene glycol (meth)acrylates such as phenoxypolyethylene glycol (meth)acrylate and phenoxypolypropylene glycol (meth)acrylate

The above-mentioned monomers (1'), (2') and (6') may be used singly, or two or more kinds of them may be used in combination. Among the above-mentioned monomers (1'), (2') and (6') are preferred N-(p-hydroxyphenyl)acrylamide, N-(p-hydroxyphenyl)methacrylamide, N-(3,5-dimethyl-4-hydroxybenzyl)acrylamide, N-(3,5-dimethyl-4-hydroxybenzyl)methacrylamide, p-hydroxyphenyl methacrylate, p-hydroxybenzyl methacrylate and phenoxypolyethylene glycol acrylate.

On obtaining the above-mentioned polymer (A), one may further copolymerize another monomer (hereafter referred to as "monomer (II)") that is copolymerizable with monomers (1'), (2'), (6'), a monomer deriving a structural unit having an acid-dissociative functional group and monomer (I).

As such monomer (II), there may be mentioned, for example, aromatic vinyl compounds such as o-hydroxystyrene, m-hydroxystyrene, p-hydroxystyrene, p-isopropenylphenol, styrene, α-methylstyrene, p-methylstyrene and p-methoxystyrene; alicyclic vinyl compounds containing a heteroatom such as N-vinylpyrrolidone and N-vinylcaprolactam; vinyl compounds containing a cyano group such as acrylonitrile and methacrylonitrile; conjugated diolefins such as 1, 3-butadiene and isoprene; vinyl compounds containing an amide group such as acrylamide and methacrylamide; vinyl compounds containing a carboxyl group such as acrylic acid and methacrylic acid; and (meth)acrylic acid esters such as methyl (meth)acrylate, ethyl (meth)acrylate, n-propyl (meth)acrylate, n-butyl (meth)acrylate, 2-hydroxyethyl (meth)acrylate, 2-hydroxypropyl (meth)acrylate, polyethylene glycol mono (meth) acrylate, polypropylene glycol mono (meth) acrylate, glycerol mono(meth)acrylate, phenyl (meth)acrylate, benzyl (meth)acrylate, cyclohexyl (meth)acrylate, isobornyl (meth)acrylate and tricyclodecanyl (meth)acrylate.

The above-mentioned monomers (II) may be used singly, or two or more kinds of them may be used in combination. Among the above-mentioned monomers (II) are preferred p-hydroxystyrene, p-isopropenylphenol, styrene, acrylic acid, methacrylic acid, methyl (meth) acrylate, ethyl (meth) acrylate, n-butyl (meth)acrylate, 2-hydroxyethyl (meth)acrylate, 2-hydroxypropyl (meth)acrylate, benzyl (meth)acrylate and isobornyl (meth)acrylate.

The content of the acid-dissociative functional group in the composition of the present invention is not particularly limited unless the effects of the present invention are deteriorated.

When the above-mentioned acid-dissociative functional group is derived from monomer (3'), the weight ratio of the structural unit derived from monomer (3') to the sum of structural units derived from monomers (1'), (2'), (3'), (6') and (II) in the polymer (A) [monomer (3')/{monomer (1') + monomer (2') + monomer (3') + monomer (6') + monomer (II)}] is usually 5/100 to 95/100, preferably 10/100 to 90/100, further preferably 20/100 to 80/100.

If the ratio of the structural unit derived from monomer (3') is lower than the above range, since the fraction of acidic functional groups to be generated is low, the solubility of the obtained polymer to an alkaline developer decreases and formation of a pattern may become difficult.

Further, the structural unit derived from monomer (I) contained in the above-mentioned polymer (A) is preferably 0.1 part by weight to 10 parts by weight, more preferably 0.5 part by weight to 5 parts by weight for 100 parts by weight of the sum of the structural units derived from the monomers (1'), (2'), (3'), (6') and (II).

If the ratio of the structural unit derived from monomer (I) is lower than the above range, crosslinking reaction does not proceed efficiently and resistance to metal plating may not be attained. On the other hand, if the ratio is higher than the above range, controlling polymerization becomes difficult and a resin with gelation or excessive high-molecularization may proceed, causing significant decrease in resolution as the resist.

When the above-mentioned polymer (A) contains the structural unit derived from monomer (1'), the weight ratio of the structural unit derived from monomer (1') to the sum of the structural units derived from monomers (1'), (2'), (3'), (6') and (II) [monomer (1')/{monomer (1') + monomer (2') + monomer (3') + monomer (6') + monomer (II)}] is usually 1/100 to 50/100, preferably 3/100 to 30/100, further preferably 5/100 to 15/100.

When the above-mentioned polymer (A) contains the structural unit derived from monomer (2'), the weight ratio of the structural unit derived from monomer (2') to the sum of the structural units derived from monomers (1'), (2'), (3'), (6') and (II) [monomer (2')/{monomer (1') + monomer (2') + monomer (3') + monomer (6') + monomer (II)}] is usually 1/100 to 50/100, preferably 5/100 to 35/100, further preferably 15/100 to 25/100.

When the above-mentioned polymer (A) contains the structural unit derived from monomer (6'), the weight ratio of the structural unit derived from monomer (6') to the sum of the structural units derived from monomers (1'), (2'), (3'), (6') and (II) [monomer (6')/{monomer (1') + monomer (2') + monomer (3') + monomer (6') + monomer (II)}] is usually 1/100 to 50/100, preferably 5/100 to 35/100, further preferably 15/100 to 25/100.

Polymer (A) can be produced, for example, by directly copolymerizing monomer (3'), monomer (I), preferably at least one monomer selected from monomers (1'), (2') and (6'), and, if necessary, monomer (II). Polymerization can be carried out by radical polymerization. A usual radical polymerization initiator such as an organic peroxide can be used as the initiator. As polymerization method, there may be mentioned, for example, emulsion polymerization, suspension polymerization, solution polymerization and bulk polymerization. In particular, solution polymerization is preferred.

The solvent used in the above-mentioned solution polymerization is not particularly limited if it does not react with monomers to be used and it dissolves a polymer to be formed. Specifically, there may be mentioned, for example, methanol, ethanol, n-hexane, toluene, tetrahydrofuran, 1,4-dioxane, ethyl acetate, n-butyl acetate, acetone, methyl ethyl ketone, methyl isobutyl ketone, 2-heptanone, cyclohexanone, ethylene glycol monomethyl ether, propylene glycol monomethyl ether, propylene glycol monomethyl ether acetate, methyl 3-methoxypropionate, ethyl 3-ethoxypropionate, ethyl lactate and γ-butyrolactone. These solvents maybe used singly, or two or more kinds of them may be used as a mixture.

The molecular weight of the above-mentioned polymer (A) can be adjusted by appropriately selecting polymerization conditions such as composition of monomers, a radical polymerization initiator, a molecular weight modifier, which may be used if necessary, and temperature. The polystyrene-equivalent weight-average molecular weight (Mw) of polymer (A) is usually 30, 000 to 150, 000 preferably 50,000 to 100,000. When the Mw value of polymer (A) is in the above range, the resin film is excellent in mechanical strength, resistance to metal plating and solubility of the polymer to an alkaline solution after exposure, facilitating formation of a fine pattern.

When polymer (A) is produced by solution polymerization, the obtained polymer solution, as prepared, may be subjected to preparation of a positive-type radiation-sensitive resin composition. Alternatively polymer (A) may be separated from the polymerization solution and then subjected to preparation of a positive-type radiation-sensitive resin composition. In the present invention, polymer (A) may be used singly, or two or more kinds of them may be used in combination.

### <Component (B)>

Acid generator (B) used in the present invention is a compound that generates an acid on exposure. By reacting with the acid thus generated, the acid-dissociative functional group in polymer (A) is dissociated to yield an acidic functional group such as a carboxyl group and a phenolic hydroxyl group. As a result, the exposed part of the resin film formed from the positive-type radiation-sensitive resin composition becomes readily soluble to an alkaline developer, and thus a positive-type pattern can be formed.

As acid generator (B), there may be mentioned, for example, onium salts (including thiophenium salts), halogen-containing compounds, diazoketones, sulfones, sulfonic acid derivatives, sulfonimides and diazomethanes.

As onium salts, there may be mentioned, for example, iodonium salts, sulfonium salts, phosphonium salts, diazonium salts and pyridinium salts. Specifically, preferred onium salts are diphenyliodonium trifluoromethanesulfonate, diphenyliodonium p-toluenesulfonate, diphenyliodonium hexafluoroantimonate, diphenyliodonium hexafluorophosphate, diphenyliodonium tetrafluoroborate, triphenylsulfonium trifluoromethanesulfonate, triphenylsulfonium hexafluorophosphate, 4-t-butylphenyldiphenylsulfonium trifluoromethanesulfonate, 4-t-butylphenyldiphenylsulfonium perfluoro-n-octanesulfonate, 4-t-butylphenyldiphenylsulfonium pyrenesulfonate, 4-t-butylphenyldiphenylsulfonium n-dodecylbenzenesulfonate, 4-t-butylphenyldiphenylsulfonium p-toluenesulfonate, 4-t-butylphenyldiphenylsulfonium benzenesulfonate and (4,7-di-n-butoxynaphthyl)tetrahydrothiophenium trifluoromethanesulfonate.

As halogen-containing compounds, there may be mentioned, for example, hydrocarbon compounds containing a haloalkyl group and heterocyclic compounds containing a haloalkyl group. Specifically, preferred halogen-containing compounds are 1,10-dibromo-n-decane, 1,1-bis(4-chlorophenyl)-2,2,2-trichloroethane and trichloromethyl-s-triazine derivatives such as phenylbis(trichloromethyl)-s-triazine, 4-methoxyphenylbis(trichloromethyl)-s-triazine, styrylbis(trichloromethyl)-s-triazine and naphthylbis(trichloromethyl)-s-triazine.

As diazoketones, there may be mentioned, for example, 1,3-diketo-2-diazo compounds, diazobenzoquinones and diazonaphthoquinones. Specifically, preferred diazoketones are 1,2-naphthoquinonediazide-4-sulfonic acid esters of phenols, 1,2-naphthoquinonediazide-5-sulfonic acid esters of phenols and the like.

As sulfones there may be mentioned, for example, β-ketosulfones, β-sulfonylsulfones and α-diazo compounds of these compounds. Specifically preferred sulfones are 4-tolyl phenacyl sulfone, mesityl phenacyl sulfone, bis(phenylsulfonyl)methane and the like.

As sulfonic acid derivatives, there may be mentioned, for example, alkylsulfonic acid esters, haloalkylsulfonic acid esters, arylsulfonic acid esters and iminosulfonic acid esters. Specifically, preferred sulfonic acid derivatives are benzoin tosylate, pyrogallol tris(trifluoromethanesulfonate), o-nitrobenzyl trifluoromethanesulfonate, o-nitrobenzyl p-toluenesulfonate and the like.

As sulfonimides, there may be mentioned, for example,
N-(trifluoromethylsulfonyloxy)succinimide,
N-(trifluoromethylsulfonyloxy)phthalimide,
N-(trifluoromethylsulfonyloxy)diphenylmaleimide,
N-(trifluoromethylsulfonyloxy)bicyclo[2.2.1]hept-5-ene-2,3-dicarboximide,
N-(trifluoromethylsulfonyloxy)-7-oxabicyclo[2.2.1]hept-5-en e-2,3-dicarboximide,
N-(trifluoromethylsulfonyloxy)-5,6-oxybicyclo[2.2.1]heptane -2,3-dicaxboximide,
N-(trifluoromethylsulfonyloxy)naphthylimide,
N-(4-methylphenylsulfonyloxy)succinimide,
N-(4-methylphenylsulfonyloxy)phthalimide,
N-(4-methylphenylsulfonyloxy)diphenylmaleimide,
N-(4-methylphenylsulfonyloxy)bicyclo[2.2.1]hept-5-ene-2,3-d icarboximide,
N-(4-methylphenylsulfonyloxy)-7-oxabicyclo[2.2.1]hept-5-ene -2,3-dicarboximide,
N-(4-methylphenylsulfonyloxy)-5,6-oxybicyclo[2.2.1]heptane-2,3-dicarboximide,
N-(4-methylphenylsulfonyloxy)naphthylimide,
N-(2-trifluoromethylphenylsulfonyloxy)succinimide,
N-(2-trifluoromethylphenylsulfonyloxy)phthalimide,
N-(2-trifluoromethylphenylsulfonyloxy)diphenylmaleimide,
N-(2-trifluoroinethylphenylsulfonyloxy)bicyclo[2.2.1]hept-5-ene-2,3-dicarboximide,
N-(2-trifluoromethylphenylsulfonyloxy)-7-oxabicyclo[2.2.1]h ept-5-ene-2,3-dicarboximide,
N-(2-trifluoromethylphenylsulfonyloxy)-5,6-oxybicyclo[2.2.1]heptane-2,3-dicarboximide,
N-(2-trifluoromethylphenylsulfonyloxy)naphthylimide,
N-(4-fluorophenylsulfonyloxy)succinimide,
N-(4-fluorophenylsulfonyloxy)-7-oxabicyclo[2.2.1]hept-5-ene -2,3-dicarboximide,
N-(4-fluorophenylsulfonyloxy)-5,6-oxybicyclo[2.2.1]heptane-2,3-dicarboximide,
N-(4-fluorophenylsulfonyloxy)naphthylimide and
N-(10-camphorsulfonyloxy)naphthylimide.

As diazomethanes, there may be mentioned, for example, bis(trifluoromethylsulfonyl)diazomethane, bis(cyclohexylsulfonyl)diazomethane, bis(phenylsulfonyl)diazomethane, bis(p-toluenesulfonyl)diazomethane, methylsulfonyl-p-toluenesulfonyldiazomethane, cyclohexylsulfonyl-1,1-dimethylethylsulfonyldiazomethane and bis(1,1-dimethylethylsulfonyl)diazomethane.

The above-mentioned acid generators (B) may be used singly, or two or more kinds of them may be used in combination. Among the above-mentioned acid generators (B), more preferred ones are 4-t-butylpheyldiphenylsulfonium trifluoromethanesulfonate, 4-t-butylphenyldiphenylsulfonium perfluoro-n-octanesulfonate, 4-t-butylphenyldiphenylsulfonium pyrenesulfonate and (4,7-di-n-butoxynaphthyl)tetrahydrothiophenium trifluoromethanesulfonate. In particular, 4-t-butylpheyldiphenylsulfonium trifluoromethanesulfonate and (4,7-di-n-butoxynaphthyl)tetrahydrothiophenium trifluoromethanesulfonate are preferred.

The amount of acid generator (B) used in preparation of the composition of the present invention is, from the viewpoint of ensuring sensitivity, resolution and pattern shape as a resist, usually 0.1 part by weight to 20 parts by weight, preferably 0.3 part by weight to 10 parts by weight, particularly preferably 1 part by weight to 5 parts by weight for 100 parts by weight of polymer (A). By setting the amount of acid generator (B) to the above range, a resist excellent in sensitivity, resolution and transparency for radiation ray can be provided, and a pattern with excellent shape is also obtained.

### <Component (C)>

In the positive-type radiation-sensitive resin composition for a metal-plating formed material of the present invention, the above-mentioned polymer (A), acid generator (B), and another alkali-soluble resin and an additive that are blended if necessary, which will be described below, may be diluted with organic solvent (C) for mixing these components homogeneously.

As such organic solvent, there may be mentioned, for example, ethylene glycol alkyl ethers such as ethylene glycol monomethyl ether, ethylene glycol monoethyl ether, ethylene glycol monopropyl ether and ethylene glycol monobutyl ether; diethylene glycol dialkyl ethers such as diethylene glycol dimethyl ether, diethylene glycol diethyl ether, diethylene glycol dipropyl ether and diethylene glycol dibutyl ether; ethylene glycol alkyl acetates such as methyl cellosolve acetate and ethyl cellosolve acetate; propylene glycol alkyl ether acetates such as propylene glycol monomethyl ether acetate, propylene glycol monoethyl ether acetate and propylene glycol monopropyl ether acetate; ketones such as acetone, methyl ethyl ketone, cyclohexanone and methyl amyl ketone; aromatic hydrocarbons such as toluene and xylene; cyclic ethers such as dioxane; and esters such as methyl 2-hydroxypropionate, ethyl 2-hydroxypropionate, 2-hydroxy-2-methylpropionate, ethyl 3-ethoxypropionate, ethyl ethoxyacetate, ethyl oxyacetate, methyl 2-hydroxy-3-methylbutanoate, 3-methoxybutyl acetate, 3-methyl-3-methoxybutyl acetate, ethyl formate, ethyl acetate, butyl acetate, methyl acetoacetate and ethyl acetoacetate. These solvents may be used singly, or two or more kinds of them may be used as a mixture.

The amount of organic solvent (C) is preferably an amount with which the solid content of the resin composition becomes 20% by weight to 65% by weight, considering coating method and use of the resin composition, although the amount of the solvent is not particularly limited as long as the composition can be homogeneously mixed. If the solid content is lower than the above range, it is difficult to obtain a film thickness of 20 µm or more, which is suitable for bump-forming materials. On the other hand, if it exceeds the above range, the fluidity of the composition is significantly deteriorated causing difficulty in handling, and uniform film thickness is unlikely attained.

### <Another alkali-soluble resin>

To the positive-type radiation-sensitive resin composition for a metal-plating formed material of the present invention, an alkali-soluble resin other than the above-mentioned component (A) (hereafter referred to as "another alkali-soluble resin (D) ") may be added if necessary.

As another alkali-soluble resin (D) usable in the present invention is a resin that contains one or more kinds of functional group with affinity to an alkaline developer, for example an acidic functional group such as a phenolic hydroxyl group and a carboxyl group, and is soluble to the alkaline developer. When such an alkali-soluble resin is added, because the dissolution rate of resin formed from the positive-type radiation-sensitive resin composition can be controlled more easily, developing characteristics can be further improved.

Another alkali-soluble resin (D) is not particularly limited as long as it is soluble to an alkaline developer. There may be mentioned, for example, an addition-polymerized resin obtained by polymerizing at least one kind of monomer having an acidic functional group such as o-hydroxystyrene, m-hydroxystyrene, p-hydroxystyrene, p-isopropenylphenol, p-vinylbenzoic acid, p-carboxymethylstyrene, p-carboxymethoxystyrene, acrylic acid, methacrylic acid, crotonic acid, maleic acid, fumaric acid, itaconic acid, citraconic acid, mesaconic acid and cinnamic acid (except the above-mentioned polymer (A)); and a condensation-polymerized resin having acidic functional groups, whose representative is Novolac resin.

The above-mentioned addition-polymerized resin may consist of a repeating unit derived by dissociation of the polymerizable unsaturated bond in the above-mentioned monomer having an acidic functional group. Alternatively, one or more kind (s) of other repeating unit may be further contained as long as the formed resin is soluble to the alkaline developer.

As the above-mentioned another repeating unit, there may be mentioned, for example, a repeating unit derived from styrene, α-methylstyrene, o-vinyltoluene, m-vinyltoluene, p-vinyltoluene, maleic anhydride, acrylonitrile, methacrylonitrile, crotononitrile, maleinonitrile, fumaronitrile, mesacononitrile, citracononitrile, itacononitrile, acrylamide, methacrylamide, crotonamide, maleinamide, fumaramide, mesaconamide, citraconamide, itaconamide, 2-vinylpyridine, 3-vinylpyridine, 4-vinylpyridine, N-vinylaniline, N-vinyl-ε-caprolactam, N-vinylpyrrolidone, N-vinylimidazole or the like.

As the above-mentioned addition-polymerized resin, poly(p-hydroxystyrene) and copolymer of p-isopropenylphenol are particularly preferred from the point that the formed resin film has high transmittance for radiation ray and excellent resistance to dry etching.

The polystyrene-equivalent weight-average molecular weight (Mw) of the above-mentioned addition-polymerized resin is usually 1,000 to 200,000, preferably 5,000 to 70,000.

The above-mentioned condensation-polymerized resin may consist of only a condensing repeating unit having an acidic functional group. Alternatively it may further contain another condensing repeating unit as long as the formed resin is soluble to the alkaline developer.

Such a condensation-polymerized resin can be produced, for example, by condensation (co)polymerization of one or more kind(s) of phenol and one or more kind(s) of aldehyde, if necessary together with the component giving another condensing repeating unit, in the presence of an acidic or basic catalyst in an aqueous medium or a mixed medium of water and a hydrophilic solvent.

As the above-mentioned phenols, there may be mentioned, for example, o-cresol, m-cresol, p-cresol, 2,3-xylenol, 2,4-xylenol, 2,5-xylenol, 3,4-xylenol, 3,5-xylenol, 2,3,5-trimethylphenol and 3,4,5-trimethylphenol. As the above-mentioned aldehydes, there may be mentioned, for example, formaldehyde, trioxane, paraformaldehyde, benzaldehyde, acetaldehyde, propylaldehyde and phenylacetaldehyde.

The polystyrene-equivalent weight-average molecular weight (Mw) of the above-mentioned condensation-polymerized resin is usually 1,000 to 100,000, preferably 2,000 to 50, 000.

These other alkali-soluble resins (D) may be used singly, or two or more kinds of them may be used in combination. The amount of the above-mentioned other alkali-soluble resin (D) is usually 200 parts by weight or less for 100 parts by weight of polymer (A).

### <Agent for controlling diffusion of an acid>

Preferably, an agent for controlling diffusion of an acid is blended in the positive-type radiation-sensitive resin composition for a metal-plating formed material of the present invention in order to control diffusion of the acid generated from acid generator (B) in the resin film and to prevent undesired chemical reaction in unexposed part. By using such an agent for controlling diffusion of an acid, the storage stability of the composition increases, the resolution as a resist is further improved and fluctuation of line width of the pattern due to fluctuation of lag time from exposure to PEB is also reduced. Thus, the process stability becomes very excellent.

The agent for controlling diffusion of an acid is preferably a nitrogen-containing organic compound whose basicity does not change on exposure or heating in the production process of a metal-plating formed material.

As the above-mentioned nitrogen-containing organic compound, there may be mentioned, for example, n-hexylamine, n-heptylamine, n-octylamine, n-nonylamine, ethylenediamine, N,N,N',N'-tetramethylethylenediamine, tetramethylenediamine, hexamethylenediamine, 4,4'-diaminodiphenylmethane, 4,4'-diaminodiphenyl ether, 4,4'-diaminobenzophenone, 4,4'-diaminodiphenylamine, formamide, N-methylformamide, N,N-dimethylformamide, acetamide, N-methylacetamide, N,N-dimethylacetamide, propionamide, benzamide, pyrrolidone, N-methylpyrrolidone, methylurea, 1,1-dimethylurea, 1,3-dimethylurea, 1,1,3,3-tetramethylurea, 1,3-diphenylurea, imidazole, benzimidazole, 4-methylimidazole, 8-oxyquinoline, acridine, purine, pyrrolidine, piperidine, 2,4,6-tri(2-pyridyl)-s-triazine, morpholine, 4-methylmorpholine, piperazine, 1,4-dimethylpiperazine and 1,4-diazabicyclo[2.2.2]octane. Among these 2,4,6-tri(2-pyridyl)-s-triazine is particularly preferred. The above-mentioned agents controlling diffusion of an acid may be used singly, or two or more kinds of them may be used in combination.

The amount of the above-mentioned agent for controlling diffusion of an acid is usually 15 parts by weight or less, preferably 0.001 part by weight to 10 parts by weight, more preferably 0.005 part by weight to 5 parts by weight for 100 parts by weight of polymer (A). By setting the amount of agent for controlling diffusion of an acid to the above range, a resist excellent in sensitivity, developing characteristic, pattern shape and dimensional fidelity can be obtained.

### <Surfactant>

To the positive-type radiation-sensitive resin composition for a metal-plating formed material of the present invention, a surfactant may be added for improving characteristics in coating, developing and others.

As such surfactant, there may be mentioned polyoxyethylene lauryl ether, polyoxyethylene stearyl ether, polyoxyethylene oleyl ether, polyoxyethylene n-octylphenyl ether, polyoxyethylene n-nonylphenyl ether, polyoxyethylene glycol dilaurate, polyoxyethylene glycol distearate and the like.

These surfactants may be used singly, or two or more kinds of them may be used in combination. The amount of the above-mentioned surfactant is usually 2 parts by weight or less for 100 parts by weight of the above-mentioned polymer (A).

### <Other additives>

As other additives that can be blended in the positive-type radiation-sensitive resin composition for a metal-plating formed material of the present invention, there may be mentioned, for example, an ultraviolet light absorber, a sensitizer, a dispersant, a plasticizer, a thermal polymerization inhibitor for increasing storage stability and an antioxidant. In particular, the ultraviolet light absorber is valuable because it prevents photochemical reaction caused by entering of scattered light into unexposed parts during exposure. A preferred ultraviolet light absorber is a compound having a high absorption coefficient in the wavelength region of ultraviolet light used for exposure. Further, organic pigments may be used for similar purposes.

To form a pattern with good shape or to reduce occurrence of crack in a coating film, a terminal-modified vinyl alkyl ether resin or a terminal-modified polyether resin may be also added.

### (Vinyl alkyl ether resin>)

As the above-mentioned terminal-modified vinyl alkyl ether resin, there may be mentioned a polymer or an oligomer represented by the following formula (4).

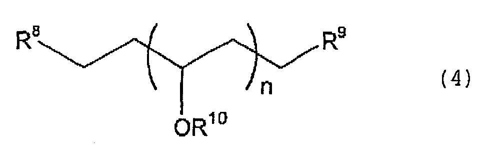

In formula (4), each of R⁸ and R⁹ is independently a hydroxyl group or a carboxyl group, and preferably they are both a hydroxyl group. R¹⁰ is an alkyl group having 1 to 4 carbon atoms, and specifically there may mentioned a methyl group, an ethyl group, an n-propyl group, an isopropyl group, an n-butyl group, an isobutyl group and the like. Preferably R¹⁰ is a methyl group or an ethyl group, especially preferably an ethyl group.

By containing such a terminal-modified vinyl alkyl ether resin in the above-mentioned positive-type radiation-sensitive resin composition, a pattern with good shape can be formed, and occurrence of crack in the coating film can be reduced. Moreover, such a vinyl alkyl ether resin modified at both terminals, compared with a vinyl alkyl ether resin having unmodified terminals, exhibits better miscibility with other resin components, improves solubility of the resin to a developer and increases resolution.

The state of the above-mentioned terminal-modified vinyl alkyl ether resin at room temperature varies from a fluidic state to a soft resin state, depending on its degree of polymerization. A resin in appropriate state can be selected to use. Accordingly n in formula (4) is, although not particularly limited, usually an integer of 1 or more, preferably 1 to 100, more preferably 10 to 50.

The above-mentioned terminal-modified vinyl alkyl ether resin is contained at an amount of 2 to 80 parts by weight, preferably 5 to 50 parts by weight, especially preferably 5 to 30 parts by weight for 100 parts by weight of component (A) in the above-mentioned positive-type radiation-sensitive resin composition. If the amount of the terminal-modified vinyl alkyl ether resin exceeds the above range, pattern shape may be deteriorated because of insufficient contrast between exposed part and unexposed part on development.

### (Polyether resin)

As the above-mentioned terminal-modified polyether resin, there may be mentioned polymers or oligomers represented by the following formulae (5a) and/or (5b).

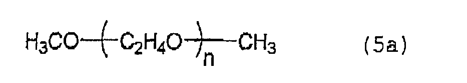

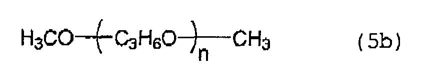

By containing such a terminal-modified polyether resin in the above-mentioned positive-type radiation-sensitive resin composition, a pattern with good shape can be formed, and occurrence of crack in the coating film can be reduced. Moreover, by using such a polyether resin modified at both terminals, compared with a case using a polyether resin having unmodified terminals, high resolution can be retained through reducing the solubility of resin to a developer to some extent.

The above-mentioned terminal-modified polyether resins at room temperature varies from those having fluidity to those having a crystalline state, depending on its degree of polymerization. An appropriate resin can be selected to use. Accordingly n in formulae (5a) and (5b) is, although not particularly limited, usually an integer of 1 or more, preferably 1 to 30, more preferably 10 to 20.

The above-mentioned terminal-modified polyether resin is contained at an amount of 2 to 50 parts by weight, preferably 5 to 30 parts by weight, especially preferably 5 to 20 parts by weight for 100 parts by weight of component (A) in the above-mentioned positive-type radiation-sensitive resin composition. If the amount of the terminal-modified polyether resin exceeds the above range, pattern shape maybe deteriorated because of insufficient contrast between exposed part and unexposed part on development.

### [Transcription film]

The transcription film of the present invention comprises a supporting film and a resin film formed from the above-mentioned positive-type radiation-sensitive resin composition for a metal-plating formed material on this supporting film. Such a transcription film can be produced by coating a supporting film with the above-mentioned composition and then dried.

As method for coating with the above-mentioned composition, there may be mentioned, for example, spin coating method, roll coating method, screen printing and applicator method. The material for supporting film is not particularly limited as long as it is durable in production and use of the transcription film.

The above-mentioned transcription film can be used with a resin film thickness of 20 µm to 200 µm. The transcription film of the present invention can serve as a positive-type radiation-sensitive resin film by peeling the supporting film off. The above-mentioned resin film, like the composition of the present invention, can be used for producing a metal-plating formed material, which will be described below.

### [Production method of a metal-plating formed material]

The production method of a metal-plating formed material relating to the present invention comprises
(1) a step of forming a resin film using the above-mentioned positive-type radiation-sensitive resin composition for producing a metal-plating formed material on a wafer equipped with a metal barrier layer,
(2) a step of forming a pattern by developing the above-mentioned resin film after exposure,
(3) a step of depositing an electrode material by electroplating with the above-mentioned pattern as a template, and
(4) a step of peeling the remaining resin film off and removing the barrier metal layer by etching.

### <Formation of a radiation-sensitive resin film>

By coating a given substrate, particularly a substrate for electronic parts, with the above-mentioned positive-type radiation-sensitive resin composition and drying (removing solvent by heating or evacuation), a radiation-sensitive resin film (resist film) with a film thickness of 5 µm to 60 µm, preferably 10 µm to 30 µm, If the film thickness of resist film is less than the above range, the thickness of bump that is formed after metal plating may be insufficient while, if it exceeds the above range, forming a uniform resin film tends to be difficult. A resist filmmay also be formed on a substrate using the above-mentioned transcription film containing a dry-film-type resist film, which is formed in advance from the positive-type radiation-sensitive resin composition for producing a metal-plating formed material of the present invention, by transcription or another technique. Adopting this method can simplify the production process.

As method of coating a substrate with the above-mentioned positive-type radiation-sensitive resin composition, there may used, for example, spin coating method, roll coating method, screen printing method and applicator method. Conditions for drying (prebake) of the coating film, which is formed by coating a substrate with the positive-type radiation-sensitive resin composition as above, depend on type of each component in the composition, blending ratio, thickness of the coating film and other parameters, but this step is carried out usually at 70 °C to 140°C, preferably at 100°C to 120°C for about 5 min to 60 min. A too short prebake time causes poor adhesion during developing, while a too long prebake time tends to cause lower resolution due to poor solubility of exposed part on developing.

### <Irradiation with radiation ray (Exposure)>

Only the patterned parts wherein bumps are to be formed are exposed by irradiating the obtained resist film with ultraviolet light or visible light with wavelength of 300 nm to 500 nm through a mask with a given pattern. As light source for such radiation ray, one may use a low-pressure mercury lamp, a high-pressure mercury lamp, a superhigh-pressure mercury lamp, a metal halide lamp, an argon gas laser and the like. Here, radiation ray means ultraviolet light, visible light, far-ultraviolet light, X-ray, electron beam or the like. The radiation dose is, for example, 100 mJ/cm² to 3,000 mJ/cm² in the case of using a superhigh-pressure mercury lamp, although it depends on type of each component in the composition, blending ratio, film thickness and other parameters.

### <PEB>

After irradiation with radiation ray, the substrate is subjected to thermal treatment (PEB) to enhance decomposition reaction of acid-dissociative functional groups in the presence of an acid in the above-mentioned resist film. Conditions for heating depend on type of each component in the composition, blending ratio, thickness of the coating film and other parameters, but this step is carried out usually at 80 °C to 140°C, preferably at 90 °C to 120°C for about 5 min to 60 min.

### <Development>

By developing the resist film with an alkaline developer after the above-mentioned PEB treatment, the part irradiated with radiation ray is dissolved to remove while only the unexposed part is allowed to remain, thus forming a desired resist pattern. The developing method is not particularly limited, and there may be mentioned, for example, liquid-filling method, dipping method, paddling method and spraying method.

As a developer, one may use, for example, an aqueous solution of an alkali such as sodium hydroxide, potassium hydroxide, sodium carbonate, sodium silicate, sodium metasilicate, ammonia, ethylamine, n-propylamine, diethylamine, di-n-propylamine, triethylamine, methyldiethylamine, dimethylethanolamine, triethanolamine, tetramethylammonium hydroxide, tetraethylammonium hydroxide, pyrrole, piperidine, 1,8-diazabicyclo[5.4.0]-7-undecene, 1,5-diazabicyclo[4.3.0]-non-5-ene. Further, one may use an aqueous solution prepared by adding a suitable amount of a water-soluble organic solvent such as methanol and ethanol or a surfactant to the above-mentioned aqueous alkaline solution as a developer. "Alkali-soluble" in the present invention means soluble to the above-mentioned aqueous alkaline solution, for example, 5% aqueous solution of sodium hydroxide.

Developing time is usually 1 min to 30 min, although it depends on type of each component in the composition, blending ratio, thickness of the dried film of the composition. Preferably, after developed, the substrate is washed with running water for 30 sec to 90 sec and then air-dried using an air-gun or the like, or dried in an oven or by spin-drying.

### <Electroplating>

The substrate patterned by development is dipped in various type of plating solution for electroplating, and electroplating is carried out at the temperature for the duration same as those commended for plating to form a metal-plating pattern reproducing pattern of the template, that is, the above-mentioned resist pattern. The above-mentioned plating solution may be gold plating solution, solder plating solution, copper plating solution, silver plating solution or the like.

### <Peeling-off treatment>

After electroplating, the resist pattern remaining on the substrate (unexposed part) can be peeled off by dipping the substrate in a stirred peeling liquid at a temperature from room temperature to 80°C for 1 min to 10 min. Thus a protruding metal plating pattern (bump) is obtained.

As the above-mentioned peeling liquid, there may be mentioned, for example, ethylene glycol alkyl ethers such as ethylene glycol monomethyl ether, ethylene glycol monoethyl ether, ethylene glycol monopropyl ether and ethylene glycol monobutyl ether; diethylene glycol dialkyl ethers such as diethylene glycol dimethyl ether, diethylene glycol diethyl ether, diethylene glycol dipropyl ether and diethylene glycol dibutyl ether; ethylene glycol alkyl acetates such as methyl cellosolve acetate and ethyl cellosolve acetate; propylene glycol alkyl ether acetates such as propylene glycol monomethyl ether acetate, propylene glycol monoethyl ether acetate and propylene glycol monopropyl ether acetate; ketones such as acetone, methyl ethyl ketone, cyclohexanone and methyl amyl ketone; aromatic hydrocarbons such as toluene and xylene; cyclic ethers such as dioxane; and esters such as methyl 2-hydroxypropionate, ethyl 2-hydroxypropionate, ethyl 2-hydroxy-2-methylpropionate, ethyl 3-ethoxypropionate, ethyl ethoxyacetate, ethyl methoxyacetate, methyl 2-hydroxy-3-methybutanoate, 3-methoxybutyl acetate, 3-methyl-3-methoxybutyl acetate, ethyl formate, ethyl acetate, butyl acetate, methyl acetoacetate and ethyl acetoacetate. These liquids may be used singly, or two or more of them may be used as a mixture.

By carrying out the above-mentioned processes, narrow-pitch bumps can be formed with high accuracy on the substrate.

### <Reflow process>

When the bump is a solder bump, a spherical bump is formed through additional reflow process. Specifically, after the resist is peeled off, the solder bump formed on the substrate is heated to melt by treating the substrate in a reflow furnace at a temperature from room temperature to 500°C for 1 min to 60 min, and thus a spherical-shaped solder plating pattern (bump) is obtained.

### EFFECT OF THE INVENTION

Using the positive-type radiation-sensitive resin composition for producing a metal-plating formed material of the present invention, because of its excellence in sensitivity and resolution, a pattern serving as a template for electroplating can be formed reproducing dimension of a mask with higher fidelity. Further, since the resin film formed from this composition is hard and resistant to deformation, the shape of the pattern serving as a template can be accurately transcribed in the electroplating step, and thus a metal-plating formed material that follows the dimension of the mask with fidelity can be formed. This resin also exhibits excellent adhesion to a substrate and can reduce occurrence of crack in the coating film during or after metal plating. Therefore, the positive-type radiation-sensitive resin composition for producing a metal-plating formed material of the present invention can be extremely suitable for using in producing a thick-film material formed by metal-plating such as a bump or a wiring in an integrated circuit device (for example, LCD driver TC).

### EXAMPLES

The present invention will be explained with examples below, but these examples give no restriction to the present invention. In the following, "part" and "%" are based on weight unless particularly noted.

### <Synthesis of polymer (A)>

### [Synthetic example 1]

p-Isopropenylphenol (36 g), isobornyl acrylate (15 g), benzyl acrylate (21 g), t-butyl acrylate (28 g) and 1,6-hexanediol diacrylate (1 g) were mixed with propylene glycol monomethyl ether (100 g) and the mixture was stirred to prepare a homogeneous solution. After this solution was bubbled with nitrogen gas for 30 min, 2,2-azobisisobutyronitrile (AIBN) (3 g) was added here, and polymerization was carried out under continuous bubbling with nitrogen gas with the reaction temperature kept at 70°C for 3 hr. AIBN (1 g) was further added and reaction was allowed to proceed for 3 hr, the temperature was raised to 80°C, and polymerization was continued for 2 hr and then at 100C° for 1 hr. After polymerization was completed, the reaction solution was mixed with a large amount of hexane to coagulate the formed polymer. Unreacted monomers were removed by repeating a procedure, wherein the polymer was redissolved to tetrahydrofuran and then coagulated with hexane, several times. The resultant material was dried at 50°C under reduced pressure to obtain polymer (A1).

### (Weight-average molecular weight)

The weight-average molecular weight of the polymer (A1) was measured by gel permeation chromatography (GPC) using GPC columns (two G2000HXL columns, one G3000HXL column and one G4000HXL column was connected in series.) available from Tosoh Corporation and monodisperse polystyrene as a standard substance under analytical conditions that a flow rate was 1.0 mL/min, tetrahydrofuran was used as an eluent and the column temperature was 40 °C.

### [Synthetic examples 2 to 15]

Polymers (A2) to (A12) and (A15), which contain crosslinking structure, and polymers (A13) and (A14), which contain no crosslinking structure, were synthesized in the same way as Synthetic example 1 except that compounds and their amounts were changed to compositions listed in Table 1.

**Table 1**

| Polymer | Weight-average molecular weight | Component (unit: g) | | | | | | | | |
|---|---|---|---|---|---|---|---|---|---|---|
| | | (a) | (b) | (c) | (d) | (e) | (f) | (g) | (h) | (i) |
| A1 | 45,000 | 36 | 15 | 21 | 28 | 0 | 1 | 0 | 0 | 0 |
| A2 | 82,000 | 36 | 15 | 21 | 28 | 0 | 2 | 0 | 0 | 0 |
| A3 | 122,000 | 36 | 15 | 21 | 28 | 0 | 3 | 0 | 0 | 0 |
| A4 | 33,000 | 36 | 15 | 21 | 28 | 0 | 0 | 1 | 0 | 0 |
| A5 | 62,000 | 36 | 15 | 21 | 28 | 0 | 0 | 2 | 0 | 0 |
| A6 | 93,000 | 36 | 15 | 21 | 28 | 0 | 0 | 3 | 0 | 0 |
| A7 | 52,000 | 36 | 15 | 21 | 28 | 0 | 0 | 0 | 1 | 0 |
| A8 | 75,000 | 36 | 15 | 21 | 28 | 0 | 0 | 0 | 1.5 | 0 |
| A9 | 102,000 | 36 | 15 | 21 | 28 | 0 | 0 | 0 | 2 | 0 |
| A10 | 42,000 | 33 | 8 | 21 | 28 | 10 | 1 | 0 | 0 | 0 |
| A11 | 79,000 | 33 | 8 | 21 | 28 | 10 | 2 | 0 | 0 | 0 |
| A12 | 110,000 | 33 | 8 | 21 | 28 | 10 | 3 | 0 | 0 | 0 |
| A13 | 12,000 | 36 | 15 | 21 | 28 | 0 | 0 | 0 | 0 | 0 |
| A14 | 11,000 | 33 | 15 | 21 | 28 | 0 | 0 | 0 | 0 | 0 |
| A15 | 110,000 | 27.3 | 25.25 | 0 | 25.25 | 0 | 1 | 0 | 0 | 22.2 |

| | | | | | | | | | | |
|---|---|---|---|---|---|---|---|---|---|---|
| (a) Mitsui Chemicals, Inc.; p-isopropenylphenol (b) Osaka Organic Chemical Industry Ltd.; isobornyl acrylate (c) Osaka Organic Chemical Industry Ltd.; benzyl acrylate (d) Osaka Organic Chemical Industry Ltd.; t-butyl acrylate (e) Showa Highpolymer Co., Ltd.; N-(p-hydroxyphenyl)methacrylamide (f) Kyoeisha Chemical Co., Ltd.; 1,6-hexanediol diacrylate (g) Osaka Organic Chemical Industry Ltd.; 2,5-dimethyl-2,5-hexanediol diacrylate (h) Kyoeisha Chemical Co., Ltd.; trimethylolpropane trimethacrylate (i) Kyoeisha Chemical Co., Ltd.; phenoxypolyethylene glycol acrylate | | | | | | | | | | |

### [Example 1]

### (Preparation of positive-type radiation-sensitive resin compositions for a metal-plating formed material)

Polymer (A1) (100 parts by weight), (4,7-di-n-butoxynaphthyl)tetrahydrothiophenium trifluoromethanesulfonate (3 parts by weight), which is acid generator (B), and 2, 4, 6-tri (2-pyridyl) -s-triazine (0.04 part by weight), which is an agent for controlling diffusion of an acid, were dissolved in propylene glycol monomethyl ether (150 parts by weight), which is organic solvent (C), and the resultant solution was filtered through Teflon^{™} membrane filter with a pore diameter of 3 µm to obtain a resin composition. The above 2,4,6-Tri(2-pyridyl)-s-triazine was added as an ethyl lactate solution containing this compound at a concentration of 1% by weight.

### (Production of a gold-sputtered substrate)

On a silicon wafer substrate with a diameter of 4 inches, a conducting layer was formed by sputtering chromium as a layer with a thickness of 500 Å followed by sputtering gold thereon as a layer with a thickness of 1,000 Å. Hereafter, this substrate whereon a conducting layer is formed is referred to as "gold-sputtered substrate".

### (Formation of a pattern)

The above-mentioned gold-sputtered substrate was coated with the above-mentioned resin composition using a spin coater and dried by heating on a hot-plate at 120°C for 5 min to form a resin film with a thickness of 25 µm. Successively, the substrate was irradiated through a patterned mask with ultraviolet light of 300 mJ/cm² to 1,500 mJ/cm² using a superhigh-pressure mercury lamp (OSRAM; HBO; output power 1, 000 W). The exposure dose was confirmedusing an illuminometer (ORC Manufacturing Co., Ltd.; UV-M10 (illuminometer body) connected with a probe UV-35 (photoreceptor)). After exposure, PEB was carried out on a hot-plate at 100°C for 5 min. Successively, the resin film was developed by dipping in a 2.38% by weight aqueous solution of tetramethylammonium hydroxide at room temperature for 1 min, the substrate was washed with running water and blown with nitrogen gas to form a pattern. Hereafter, this substrate whereon a pattern is formed is referred to as "patterned substrate".

### (Formation of a metal-plating formed material)

As pretreatment for electroplating, the above-mentioned patterned substrate was subjected to ashing treatment with oxygen plasma (output power 100 W, oxygen flow rate 100 mL/min, treating time 1 min) to make the surface hydrophilic. Next, this substrate was dipped in 1 L of cyanide-free gold plating solution (N. E. Chemcat Corp.; trade name "ECF-88K") and electroplating was carried out for 30 min under conditions wherein the plating-bath temperature was set to 70°C and the current density set to 0.8 A/dm² to form a metal-plating formed material with a thickness of 15 µm to 18 µm, which served as a bump. The substrate was washed with running water and dried by blowing with nitrogen gas. Then, the resin film was peeled off by dipping the substrate in N-methylpyrrolidone at room temperature for 20 min to obtain a substrate having a metal-plating formed material. Hereafter, this substrate having a metal-plating formed material is referred to as "metal-plated substrate". (Evaluation)

### (1) Sensitivity

The optimal exposure dose was defined as an exposure dose with which the bottom dimension of stripped pattern becomes 30 µm when a 40 µm-pitch pattern (30 µm-width stripped pattern/10 µm-width remaining pattern), wherein the dimensions referred to designed dimensions of a mask, was formed on the above-mentioned gold-sputtered substrate. Sensitivity was evaluated based on this optimal exposure dose. The results are shown in Table 3.

### (2) Resolution

Two sheets of patterned substrates were prepared by forming each of two kinds of 40 µm-pitch patterns (30 µm-width strippedpattern/10 µm-width remaining pattern; and 32 µm-width stripped pattern/8 µm-width remaining pattern), wherein the dimensions referred to the designed dimensions of masks, on each sheet of the above-mentioned gold-sputtered substrate. The obtained patterned substrates were observed with an optical microscope and a scanning electron microscope, and resolution was evaluated on the following criterion. The results are shown in Table 3.
A : A 32 µm-width stripped pattern/8 µm-width remaining pattern can be resolved
B : A 30 µm-width stripped pattern/10 µm-width remaining pattern can be resolved but a 32 µm-width stripped pattern/8 µm-width remaining pattern cannot be resolved.
C : A 40 µm-pitch pattern cannot be resolved or cannot be resolved with good reproducibility.

### (3) Crack resistance

After a metal-plating formed material, which served as a bump, was formed on a patterned substrate in the same way as the above-mentioned formation of a metal-plating formed material, the substrate was washed with running water and dried by blowing with nitrogen gas. This substrate (substrate from which the resin film was not peeled off) was kept in a clean room wherein the room temperature was set to 23°C and the humidity was set to about 45%. After 3 hr and 24 hr, the substrate surface was observed with an optical microscope. Crack resistance was evaluated on the following criterion. The results are shown in Table 3.
A : No crack occurs in remaining patterns after 24 hr.
B : No crack occurs in remaining patterns after 3 hr but crack occurs in remaining patterns after 24 hr.
C : Crack occurs in remaining patterns after 3 hr.

Here "remaining pattern" corresponds to resist pattern.

### (4) Shape of a metal-plating formed material (A)

A metal-plated substrate wherein a metal-plating formed material was formed on a patterned substrate with a 40 µm-pitch pattern (30 µm-width stripped pattern/10 µm-width remaining pattern), wherein the dimensions referred to the mask dimensions, was observed with an optical microscope and an electron microscope. Shape of the metal-plating formed material was evaluated on the following criterion. The results are shown in Table 3.
A : The metal-plating material is transcribed from the pattern shape formed from the resin film with fidelity, and no push-in is observed or extent of push-in is 0.5 µm or less.
B : The metal-plating material exhibits push-in in a range of 0.5 µm to 1 µm compared with the pattern shape formed from the resin film.
C : The metal-plating material exhibits push-in exceeding 1 µm compared with the pattern shape formed from the resin film.

### (5) Shape of a metal-plating formed material (B)

A metal-plated substrate wherein a metal-plating formed material was formed on a patterned substrate with a 40 µm-pitch pattern (30 µm-width stripped pattern/10 µm-width remaining pattern), wherein the dimensions referred to the mask dimensions, was observed with an optical microscope and an electron microscope. Shape of the metal-plating formed material was evaluated on the following criterion. The results are shown in Table 3.
A : The bottom of metal-plating material is transcribed from the pattern shape formed from the resin film with fidelity, and no trace of percolation of metal plating is observed at the bottom of pattern.
C : The bottom of metal-plating material is not transcribed from the pattern shape formed from the resin film with fidelity, and trace of percolation of metal plating is observed at the bottom of pattern

### [Examples 2 to 15]

Formation of patterns, formation of metal-plating formed materials and evaluation were carried out in the same way as Example 1 except that the resin compositions were prepared with the compositions listed in Table 2. The results are shown in Table 3. Here, resin (E1) is a terminal-modified vinyl alkyl ether resin represented by the above formula (4) (Kyowa Hakko Chemical Co., Ltd.; TOE-1000C), while resin (E2) is a terminal-modified polyether resin represented by the above formula (5a) (NOF Corp.; MM-1000).

### [Comparative examples 1 and 2]

Formation of patterns, formation of metal-plating formed materials and evaluation were carried out in the same way as Example 1 except that the resin compositions were prepared with the compositions listed in Table 2. The results are shown in Table 3.

**Table 2**

| | Polymer (A) | | Acid generator (B) | Organic solvent (C) | Agent controlling for diffusion of an acid | Additive (E) | |
|---|---|---|---|---|---|---|---|
| | Type | Parts | Parts | Parts | Part | Type | Parts |
| EX. 1 | A1 | 100 | 3 | C1:150 | 0.04 | - | - |
| EX. 2 | A2 | 100 | 3 | C1:150 | 0.04 | - | - |
| EX. 3 | A2 | 100 | 3 | C1:150 | 0.04 | E1 | 5 |
| EX. 4 | A2 | 100 | 3 | C1:150 | 0.04 | E2 | 5 |
| EX. 5 | A3 | 100 | 3 | C1:150 | 0.04 | - | - |
| EX. 6 | A4 | 100 | 3 | C1:150 | 0.04 | - | - |
| EX.7 | A5 | 100 | 3 | C1:750 | 0.04 | - | - |
| EX. 8 | A6 | 100 | 3 | C1:150 | 0.04 | - | - |
| EX. 9 | A7 | 100 | 3 | C1:150 | 0.04 | - | - |
| EX.10 | A8 | 100 | 3 | C1:150 | 0.04 | - | - |
| EX. 11 | A9 | 100 | 3 | C1:150 | 0.04 | - | - |
| EX. 12 | A10 | 100 | 3 | C1:150 | 0.04 | - | - |
| EX.13 | A11 | 100 | 3 | C1:150 | 0.04 | - | - |
| EX. 14 | A12 | 100 | 3 | C1:150 | 0.04 | - | - |
| EX. 15 | A15 | 100 | 5 | C2:150, C3:4 | 0.04 | - | - |
| Comp. Ex. 1 | A13 | 100 | 3 | C1:150 | 0.04 | - | - |
| Comp. Ex. 2 | A14 | 100 | 3 | C1:150 | 0.04 | - | - |

| | | | | | | | |
|---|---|---|---|---|---|---|---|
| Acid generator (B): (4,7-di-n-butoxynaphthyl)tetrahydrothiophenium trifluoromethanesulfonate Organic solvent (C): (C1) propylene glycol monomethyl ether (C2) propylene glycol monomethyl ether acetate (C3) ethyl lactate Agent for controlling diffusion of an acid: 2,4,6-tri(2-pyridyl)-s-triazine Resin (E1); a terminal-modified vinyl alkyl ether resin (Kyowa Hakko Chemical Co., Ltd.; TOE-1000C) Resin (E2): a terminal-modified polyether resin (NOF Corp.; MM-1000) | | | | | | | |

**Table 3**

| | Sensitivity (mJ/cm²) | Resolution | Crack resistance | Shape of metal plating | |
|---|---|---|---|---|---|
| | | | | A | B |
| EX. 1 | 350 | A | B | A | A |
| EX. 2 | 350 | A | A | A | A |
| EX. 3 | 350 | A | A | A | A |
| EX. 4 | 300 | A | A | A | A |
| EX. 5 | 400 | A | A | A | A |
| EX.6 | 300 | A | B | B | A |
| EX. 7 | 250 | A | A | B | A |
| EX. 8 | 200 | A | A | A | A |
| EX. 9 | 350 | A | B | B | A |
| EX.10 | 400 | A | A | A | A |
| EX.11 | 450 | A | A | A | A |
| EX.12 | 500 | A | B | B | A |
| EX.13 | 600 | A | B | B | A |
| EX.14 | 700 | A | A | A | A |
| EX.15 | 200 | A | A | A | A |
| Comp. Ex. 1 | 300 | A | C | C | A |
| Comp. Ex. 2 | 350 | A | C | C | A |

The positive-type radiation-sensitive resin composition for producing a metal-plating formed material relating to the present invention comprises (A) a polymer containing a structural unit having an acid-dissociative functional group, which is dissociated in the presence of an acid to generate an acidic functional group, and a crosslinking structure; (B) a radiation-sensitive acid generator; and (C) an organic solvent. The positive-type radiation-sensitive resin composition is excellent in sensitivity and resolution, exhibits excellent adhesion to a substrate, leaves no residue at an opening after development, and is capable of preventing occurrence of crack in the resin film after metal plating and push-in of plated metal into the resin film.

## Claims

1. A positive-type radiation-sensitive resin composition for producing a metal-plating formed material comprising:
(A) a polymer containing a structural unit having an acid-dissociative functional group, which is dissociated in the presence of an acid to generate an acidic functional group, and a crosslinking structure;
(B) a radiation-sensitive acid generator; and
(C) an organic solvent.

2. The positive-type radiation-sensitive resin composition for producing a metal-plating formed material according to claim 1, wherein the polystyrene-equivalent weight-average molecular weight of the above-mentioned polymer (A) determined with gel permeation chromatography is in a range of 30,000 to 150,000.

3. The positive-type radiation-sensitive resin composition for producing a metal-plating formed material according to claim 1 or claim 2, wherein said polymer (A) further contains at least one structural unit selected from structural units represented by the following formulae (1), (2) and (6) : 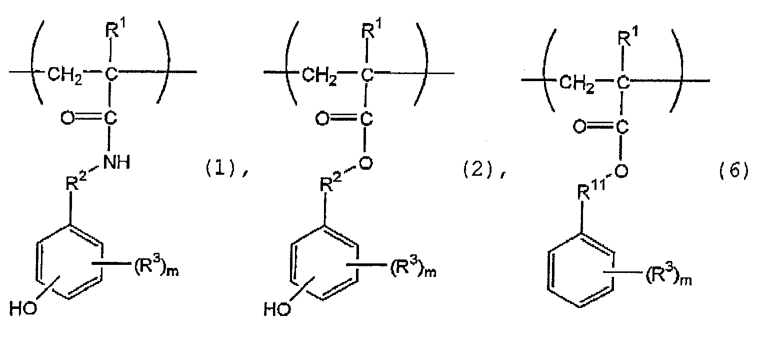 in formulae (1), (2) and (6), R¹ is a hydrogen atom or a methyl group; R⁷ is -(CH₂)ⱼ- (j is an integer of 0 to 3); R³ is a hydrogen atom or an alkyl group having 1 to 4 carbon atoms; R¹¹ is -(CH₂CH₂O)ₖ- or -(CH₂CH₂CH₂O)ₖ- (k is an integer of 1 to 4); and m is an integer of 1 to 4.

4. The positive-type radiation-sensitive resin composition for producing a metal-plating formed material according to any one of claims 1 to 3, wherein the structural unit having an acid-dissociative functional group in the above-mentioned polymer (A) is represented by the following formula (3): 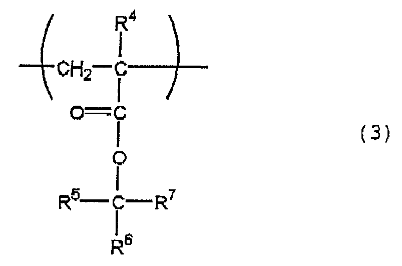 in formula (3), R⁴ is a hydrogen atom or a methyl group; each of R⁵ -R⁷ is independently an alkyl group having 1 to 4 carbon atoms, an alicyclic hydrocarbon group having 4 to 20 carbon atoms, a group containing an aromatic ring or a substituted hydrocarbon group wherein at least one hydrogen atom in these groups are substituted with a polar group other than hydrocarbon groups; and when two of R⁵-R⁷ are alkyl groups or substituted alkyl groups, their alkyl chains may bond to each other to form an alicyclic hydrocarbon group having 4 to 20 carbon atoms or a substituted alicyclic hydrocarbon group.

5. The positive-type radiation-sensitive resin composition for producing a metal-plating formed material according to any of claims 1 to 4, wherein the above-mentioned polymer (A) is a copolymer obtained by reacting at least a monomer that derives a structural unit having an acid-dissociative functional group and a monomer having two or more ethylenic unsaturated double bonds.

6. The positive-type radiation-sensitive resin composition for producing a metal-plating formed material according to any of claims 1 to 5, wherein the component (B) is contained at a range of 0.1 part by weight to 20 parts by weight for 100 parts by weight of the above-mentioned component (A).

7. The positive-type radiation-sensitive resin composition for producing a metal-plating formed material according to any of claims 1 to 6, which further comprises an alkali-soluble resin (D) other than the above-mentioned polymer (A).

8. The positive-type radiation-sensitive resin composition for producing a metal-plating formed material according to any of claims 1 to 7, which further comprises an agent for controlling diffusion of an acid.

9. The positive-type radiation-sensitive resin composition for producing a metal-plating formed material according to any of claims 1 to 8, wherein the above-mentioned component (B) is at least one kind of compound selected from the group consisting of 4-t-butylphenyldiphenylsulfonium trifluoromethanesulfonate, 4-t-butylphenyldiphenylsulfonium perfluoro-n-octanesulfonate, 4-t-butylphenyldiphenylsulfonium pyrenesulfonate and (4,7-di-n-butoxynaphthyl)tetrahydrothiophenium trifluoromethanesulfonate.

10. The positive-type radiation-sensitive resin composition for producing a metal-plating formed material according to any of claims 1 to 9, wherein the above-mentioned. metal-plating formed material is a bump.

11. A transcription film comprising a supporting film and a resin film formed using the positive-type radiation-sensitive resin composition for producing a metal-plating formed material according to any of claims 1 to 10 on said supporting film.

12. The transcription film according to claim 11 wherein the film thickness of the above-mentioned resin film is in a range between 20 µm and 200 µm.

13. A production method of a metal-plating formed material comprising:
(1) a step of forming a resin film using the positive-type radiation-sensitive resin composition for producing a metal-plating formed material according to any of claims 1 to 10 on a wafer provided with a barrier metal layer;
(2) a step of forming a pattern by exposing the above-mentioned resin film followed by developing;
(3) a step of depositing an electrode material by electroplating with the above-mentioned pattern as a template; and
(4) a step of removing the barrier metal layer by etching after peeling the remaining resin film off.

14. The production method of a metal plating formed material according to claim 13, wherein the resin film in the above step (1) is formed by transcribing the resin film in the transcription film according to claim 11 or claim 12 on the wafer.
